# EUROPÄISCHE PATENTSCHRIFT

(11) **EP 0 750 352 B1**
(45) Veröffentlichungstag und Bekanntmachung des Hinweises auf die Patenterteilung: **22.08.2001**
(21) Anmeldenummer: 96108436.5
(22) Anmeldetag: 28.05.1996
(51) Int. Cl.: H01L 29/812, H01L 29/735, H01L 29/417, H01L 29/423

(54) **Halbleiter-Bauelement-Konfiguration**
Semiconductor device layout
Configuration d'un dispositif semi-conducteur

(30) Priorität: 20.06.1995 DE 19522364
(43) Veröffentlichungstag der Anmeldung: 27.12.1996
(73) Patentinhaber: Infineon Technologies AG, 81669 München (DE)
(72) Erfinder: Ponse, Frederik, Dr., 82008 Unterhaching (DE)
(74) Vertreter: Zedlitz, Peter, Dipl.-Inf.

(56) Entgegenhaltungen:
- EP-A- 0 494 625
- US-A- 4 908 680
- E. M. BASTIDA ET AL: "AIR BRIDGE FET DEVICES FOR HIGH-PERFORMANCE MICROWAVE CIRCUITS" 15TH EUROPEAN MICROWAVE CONFERENCE . MONDAY 9TH TO FRIDAY 13TH SEPTEMBER 1985, PALAIS DES CONGRES, PARIS, FRANCE, Seiten 239-244, XP002053743
- PATENT ABSTRACTS OF JAPAN vol. 095, no. 004, 31.Mai 1995 & JP 07 029919 A (SUMITOMO ELECTRIC IND LTD), 31.Januar 1995,
- PATENT ABSTRACTS OF JAPAN vol. 016, no. 385 (E-1249), 17.August 1992 & JP 04 125941 A (OKI ELECTRIC IND CO LTD), 27.April 1992,

## Beschreibung

Die Erfindung bezieht sich auf ein Halbleiter-Bauelement mit einem Halbleitersubstrat und wenigstens einem auf dem Halbleitersubstrat ausgebildeten Transistor mit ersten, zweiten und dritten auf einer Hauptoberfläche des Halbleitersubstrats ausgebildeten und voneinander elektrisch isolierten Elektrodenanschlußbereichen, von denen einer dem Gate- bzw. Basisanschluß, einer dem Source- bzw. Emitteranschluß, und einer dem Drain- bzw. Kollektoranschluß des wenigstens einen Transistors zugeordnet ist, wobei jeder Elektrodenanschlußbereich aus zumindest einem Fingerabschnitt und einem mit dem zugehörenden Fingerabschnitt elektrisch leitend verbundenen Kontaktflachenabschnitt ausgebildet ist. Insbesondere weist der zumindest eine Fingerabschnitt eine gegenüber der Erstreckung in der Breite erheblich größere Längserstreckung auf, ist die Fläche des Kontaktflächenabschnitts gegenüber der Fläche jedes einzelnen Fingerabschnittes des Elektrodenanschlußbereiches erheblich vergrößert, und sind die Fingerabschnitte der Elektrodenanschlußbereiche wenigstens annähernd parallel zueinander ausgerichtet auf dem Halbleitersubstrat angeordnet.

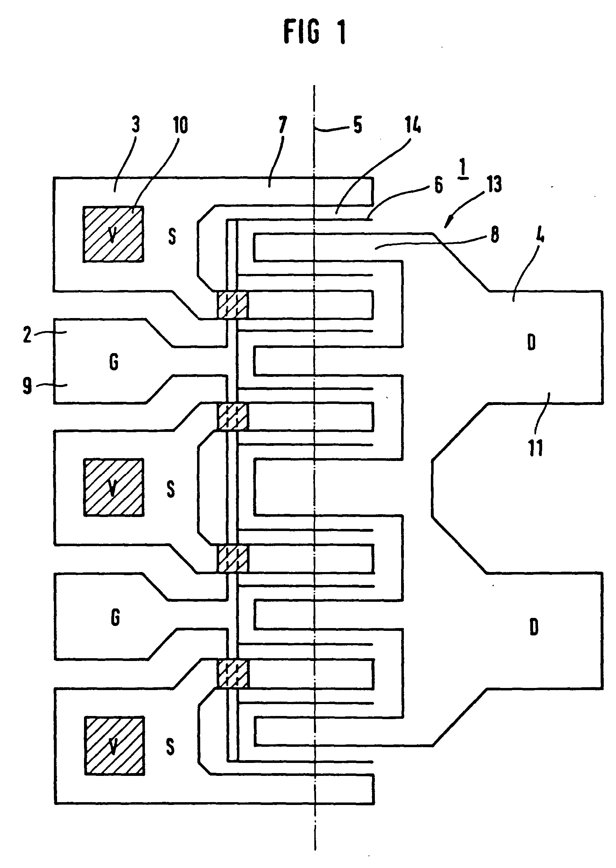

Bei bisher bekannten GaAs-Feldeffekttransistoren mit Multifingeranordnung, insbesondere solchen für Hochfrequenzanwendungen, wird üblicherweise auf einer Seite des eigentlichen aktiven FET-Bereichs eine Reihe von Drain-Bondpads, und auf der anderen Seite alternierend eine Reihe von Gate-Bondpads und eine Reihe von Source-Vias (metallisiertes Loch durch das semiisolierende Substrat zur Durchkontaktierung zur Rückseite) vorgesehen. Eine derartige Anordnung ist beispielsweise in den Datenblättern NE 9004 (NEC), JS8855-AS (Toshiba), CFX 91 (Philips), FLR056 XV (Fujitsu) beschrieben und anhand der in Fig. 1 dargestellten schematischen Draufsicht im weiteren näher erläutert. Zweck einer solchen Anordnung ist eine möglichst induktivitätsarme Verbindung zur äußeren Schaltung, insbesondere im Hinblick auf die gegenkoppelnde Source-Induktivität, welche sonst das Hochfrequenzverhalten negativ beeinflußt. Zur effektiven Wärmeableitung wurden die bisherigen Chips vor allem dünn ausgebildet. Bei der in Fig. 1 gezeigten schematischen Draufsicht ist ein herkömmliches Halbleiterbauelement mit einem Halbleitersubstrat 1 aus GaAs und eine Reihe von auf dem Halbleitersubstrat ausgebildeter Transistoren mit einem dem Gate- bzw. Basisanschluß zugeordneten Elektrodenanschlußbereich 2, einem dem Source- bzw. Emitteranschluß zugeordneten Elektrodenanschlußbereich 3, und einem dem Drain- bzw.Kollektoranschluß zugeordneten Elektrodenanschlußbereich 4 vorgesehen. Jeder Anschlußbereich 2, 3 und 4 besteht aus parallel zueinander ausgerichtet und in Richtung einer Fingerabschnitte 5 nebeneinander verlaufender Fingerabschnitte 6, 7 und 8, und Kontaktflächenabschnitte 9, 11 bzw. Via-Kontaktflächen 10 mit einer gegenüber den Fingerabschnitten 7, 6 und 8 vergrößerten Fläche. Bei der vorbekannten Anordnung sind die Kontaktflachenabschnitte 9 und 10 für die Gateanschlüsse und die Sourceanschlüsse alternierend in einer Reihe auf der einen Seite gegenüber der Fingerabschnitte 5 angeordnet, während die Kontaktflächenabschnitte 4 der Drainanschlüsse auf der gegenüberliegenden Seite der Fingerabschnitte 5 ausgerichtet sind. Die Source-Kontaktflächen können dabei außer als Source-Vias auch als normale Kontaktflächen an der Oberfläche des Halbleitersubstrats ausgebildet sein.

Der Erfindung liegt die Aufgabe zugrunde, ein Halbleiter-Bauelement der gattungsgemäßen Art zur Verfügung zu stellen, welches bei einem allenfalls geringfügig erhöhten Flächenbedarf eine vergrößerte elektrische Leitfähigkeit und Stromtragfähigkeit insbesondere der Fingerabschnitte und zugleich eine Verringerung des effektiven Wärmewiderstandes, sowie eine deutliche Verringerung der parasitären Source- bzw. Emitter-Induktivität ermöglicht.

Diese Aufgabe wird durch ein Halbleiter-Bauelement gemäß Anspruch 1 gelöst.

Das erfindungsgemäße Halbleiter-Bauelement zeichnet sich dadurch aus, daß wenigstens ein Elektrodenanschlußbereich, dessen Kontaktflächenabschnitt auf der einen Seite bezüglich der Fingerabschnitte angeordnet ist, einen weiteren mit dem zugehörenden Fingerabschnitt elektrisch verbundenen Kontaktflächenabschnitt, der auf der gegenüberliegenden Seite bezüglich der Fingerabschnitte angeordnet ist. Die weiteren Kontaktflächenabschnitte weisen vorteilhafterweise eine gegenüber jedem einzelnen Fingerabschnitt vergrößerte Fläche auf.

Die erfindungsgemäße Anordnung bietet den Vorteil, insbesondere bei einem ausreichend kleinen Abstand der Kontaktflächenabschnitte zum aktiven Bereich des Transistors und ausreichend dicker Metallisierung der Elektrodenanschlußbereiche, vor allem der Vias, eine erhebliche Verringerung des effektiven Wärmewiderstandes zu ermöglichen, so daß die aufgrund der elektrischen Verlustleistung vor allem im aktiven Bereich des Transistors entstehende Wärme besser abgeführt werden kann. Hierbei ist anzumerken, daß Metalle im allgemeinen eine weit mehr als eine Größenordnung bessere Wärmeleitfähigkeit besitzen als die üblichen Halbleitermaterialien Si oder GaAs, so daß bereits dünne Metallschichten eine wesentliche Verringerung des thermischen Widerstandes ermöglichen können.

Dem Prinzip der Erfindung folgend ist vorgesehen, daß wenigstens ein Elektrodenanschlußbereich, dessen Kontaktflächenabschnitt auf der einen Seite bezüglich der Fingerabschnitte angeordnet ist, einen mit diesem Kontaktflächenabschnitt und/oder dem zugehörenden weiteren Kontaktflächenabschnitt elektrisch verbundenen weiteren Fingerabschnitt aufweist. Der weitere Fingerabschnitt kann in einen mit diesem elektrisch verbundenen Verbreiterungsabschnitt münden, der auf der gegenüberliegenden Seite bezüglich der Fingerabschnitte angeordnet ist und eine gegenüber dem weiteren Fingerabschnitt zumindest etwas vergrößerte Breite aufweist. Hierbei ist vorgesehen, daß der weitere Fingerabschnitt über einen Steg mit dem Fingerabschnitt und/oder dem weiteren Kontaktflächenabschnitt auf der gegenüberliegenden Seite bezüglich der Fingerabschnitte des zugehörenden Elektrodenanschlußbereiches elektrisch verbunden ist. Weiterhin ist vorgesehen, daß der Fingerabschnitt eines auf der gegenüberliegenden Seite und zum Steg nächstliegend angeordneten Kontaktflächenabschnittes eines benachbarten Elektrodenanschlußbereiches den Steg elektrisch isolierend überkreuzend unter Bildung einer Kreuzungsstelle ausgebildet ist.

Bei einer bevorzugten Anordnung gemäß der Erfindung kann weiterhin vorgesehen sein, daß der dem Gate- bzw. Basisanschluß des Transistors zugeordnete Elektrodenanschlußbereich eine Vielzahl von Fingerabschnitten besitzt, die elektrisch leitend mit dem zugehörigen Kontaktflächenabschnitt des dem Gate- bzw. Basisanschluß des Transistors zugeordneten Elektrodenanschlußbereiches verbunden und parallel zwischen den Fingerabschnitten der dem Source- bzw. Emitteranschluß und dem Drain- bzw. Kollektoranschluß des Transisters zugeordneten Elektrodenanschlußbereichen verlaufen.

In weiterer Ausgestaltung des erfindungsgemäßen Halbleiter-Bauelementes kann vorgesehen sein, daß die Vielzahl von Fingerabschnitten des dem Gate- bzw. Basisanschluß des Transistors zugeordneten Elektrodenanschlußbereiches über eine Zuleitung mit dem dazugehörenden Kontaktflächenabschnitt des Gate- bzw. Basisanschlusses verbunden sind. Hierbei ist von Vorteil, wenn der Fingerabschnitt des auf der einen Seite bezüglich der Fingerabschnitte angeordneten Kontaktflächenabschnittes eines Elektrodenanschlußbereiches die dem Gate- bzw. Basisanschluß des Transistors zugeordnete Zuleitung elektrisch isolierend überkreuzend unter Bildung einer Kreuzungsstelle ausgebildet ist.

Die Kreuzungsstellen können hierbei als Metall-Isolatorschicht-Metallkreuzung (MIM-Kreuzung) oder als Luftbrücke ausgebildet sein.

In Weiterführung der Erfindung kann vorgesehen sein, daß die einen Kontaktflächenabschnitte der dem Source- bzw. Emitteranschluß der Transistoren zugeordneten Elektrodenanschlußbereiche und der Kontaktflächenabschnitt der dem Gate- bzw. Basisanschluß der Transistoren zugeordneten Elektrodenanschlußbereiche abwechselnd und in einer Reihe auf der einen Seite bezüglich der Fingerabschnitte ausgerichtet sind, und die weiteren Kontaktflachenabschnitte der dem Source- bzw. Emitteranschluß der Transistoren zugeordneten Elektrodenanschlußbereiche und die Kontaktflächenabschnitte der dem Drain- bzw. Kollektoranschluß der Transistoren zugeordneten Elektrodenanschlußbereiche auf der gegenüberliegenden Seite bezüglich der Fingerabschnitte abwechselnd und in einer Reihe ausgerichtet sind.

Bei einer besonders bevorzugten Ausführung des erfindungsgemäßen Halbleiter-Bauelementes kann vorgesehen sein, daß die Verbindung auf denjenigen Fingerabschnitten, die dem Source- bzw. Emitteranschlußbereich des Transistors zugeordnet sind, unter Bildung einer isolierenden Kreuzungsstelle über die dem Gate- bzw. Basisanschluß des Transistors gehörenden Zuleitung geführt ist, und gleichzeitig auf der gegenüberliegenden Seite bezüglich der Fingerabschnitte unter Bildung von ebenfalls isolierenden Kreuzungsstellen als Stege unterhalb der zum dritten Elektrodenanschlußbereich (welcher dem Drain- bzw. Kollektoranschluß des Transistors zugeordnet ist) zugehörenden Zuführungen geführt ist.

Die Anschluß- bzw. Kreuzungsanordnung gemäß dem erfindungsgemäßen Halbleiter-Bauelement erlaubt eine wesentlich effektivere Wärmeableitung, was ansonsten den Einsatz von maximalen Metallisierungsdicken für die Zuführungen erfordert. Dem Prinzip der Erfindung folgend werden zum Anschluß der inneren FET-Zellen (die den eigentlichen aktiven FET-Bereich bilden) an die äußere Umgebung, vorliegend die Kontaktflächenabschnitte, vorteilhaft zwei Arten von Leitungskreuzungen eingesetzt: Auf der Gate- bzw. Basisanschlußseite (d.h. auf der einen Seite bezüglich der Fingerabschnitte) kreuzt eine Verbindungsmetall-Ebene als Source- bzw. Emitteranschluß die Gate- bzw. Basiszuführung, auf der Drain- bzw. Kollektoranschlußseite (d.h. auf der gegenüberliegenden Seite bezüglich der Fingerabschnitte) kreuzt beispielsweise dieselbe Verbindungsmetall-Ebene diesmal als Drain- bzw. Kollektoranschluß die Source- bzw. Emitterzuführung, welche hier im Kreuzungsbereich beispielsweise lediglich aus Ohm-Metall bestehen könnte. Darüber hinaus können die unteren Kreuzungsmetalle mit einer zusätzlichen Verbindungsmetall-Ebene verstärkt sein, falls dies aus Widerstands- oder Elektromigrationsgründen sinnvoll erscheint.

Bei einer weiteren, insbesondere bevorzugten Ausgestaltung der Erfindung kann vorgesehen sein, daß die einen Kontaktflächenabschnitte und/oder die weiteren Kontaktflächenabschnitte der dem Source- bzw. Emitteranschluß des wenigstens einen Transistors zugeordneten Elektrodenanschlußbereiches eine Substratdurchkontaktierung aufweisen. Auf diese Weise kann vorteilhaft die Induktivität zur Rückseite bei der Durchkontaktierung insbesondere von hochohmigen Substraten minimiert werden. Die Ground-Induktivität kann insbesondere bei einer Ausbildung von zwei Substratdurchkontaktierungs-Reihen (Via-hole-Reihen) auf beiden Seiten bezüglich der Fingerabschnitte weiterhin minimiert werden, wobei der Flächenbedarf nur geringfügig höher ist als bei der herkömmlichen Anordnung mit nur einer Via-hole-Reihe auf nur einer Seite bezüglich der Fingerabschnitte. Sind diese Durchkontaktierungen ausreichend nahe am aktiven Bereich angeordnet (Abstand in der Größenordnung der Substratdicke oder kleiner), so ist der thermische Widerstand zur Wärmesenke (Rückseite des Halbleitersubstrats) deutlich verringert, insbesondere bei einer gegenüber den Fingerabschnitten bzw. der Mittenlinie beidseitigen Anordnung der dem Source- bzw. Emitteranschluß des Transistors zugeordneten Kontaktflächenabschnitte gemäß der Erfindung.

Beide Effekte bei dieser Ausbildung des erfindungsgemäßen Halbleiter-Bauelementes, also die Minimierung der Induktivität zur Rückseite bei der Durchkontaktierung und die Verminderung des Wärmewiderstandes können zusammen erzielt werden, sind aber auch unabhängig voneinander einsetzbar, wobei beispielsweise die bessere Wärmeableitung insbesondere bei Leistungsanwendungen im Vordergrund steht, und die minimierte Source-Induktivität beispielsweise bei Low-Noise-Bauelementen eine größere Rolle spielt.

Die erfindungsgemäße Anschlußausführung zu den äußeren Kontaktflächenabschnitten bzw. Pads erlaubt es somit, insbesondere auch in den inneren FET-Zellen sowohl die Source- bzw. Emitter- als auch auf die Drain- bzw. Kollektorflächen voll mit der bzw. den Verbindungsmetallebenen zu belegen, so daß auf allen Fingern die elektrische Leitfähigkeit und die Stromtragfähigkeit erhöht sind, und letztlich Elektromigrationsprobleme wenigstens vermindert werden.

Das erfindungsgemäße Halbleiter-Bauelement findet Anwendung bei FETs, Bipolar-Transistoren und ähnlichen Bauelementen, insbesondere auch für Hochfrequenzanwendungen, sowie monolithisch integrierten Schaltkreisen, die solche Bauelemente enthalten. Begrifflich können die dem Source- bzw. Emitterabschnitt zugeordneten Bestandteile mit den dem Drain- bzw. Kollektorabschnitt oder dem Gate- bzw. Basisanschluß zugewiesenen Bestandteile vertauscht werden, so daß beispielsweise die äußeren Kontaktflächenabschnitte bzw. Pads in den entsprechenden Pad-Reihen auch aus Gateabschnitten oder Drainabschnitten anstelle aus Sourceabschnitten bestehen können. Anstelle der Source-Vias können auch Source-Pads verwendet werden, wobei hierbei selbstverständlich der Aspekt des thermischen Widerstandes beim Via entfällt. Dennoch ergeben sich auch hier noch thermische Vorteile aufgrund der größeren metallisierten Fläche und damit verbunden eine bessere Wärmeverteilung an der Oberfläche des Halbleitersubstrates.

Die erfindungsgemäßen Vorteile gelten sowohl für einen Grund-Chip (nur jeweils ein Drain- und Gate-Pad oder Anschluß), für Vielfingerstrukturen ("beliebig" viele Gate- und Drain-Pads) als auch für MMICs mit entsprechenden FET-Zellen und weitere vergleichbare andere Halbleiter-Bauelemente.

Weitere Merkmale, Vorteile und Zweckmäßigkeiten der Erfindung ergeben sich aus der Beschreibung eines Ausführungsbeispieles anhand der Zeichnung. Es zeigt:
Figur 1 eine schematische Draufsicht eines herkömmlichen GaAs-Feldeffekttransistors mit Multifingeranordnung, und
Figur 2 eine schematische Draufsicht eines erfindungsgemäßen Halbleiter-Bauelementes mit beidseitigen Durchkontaktierungsreihen und besonderer Anschlußtopologie.

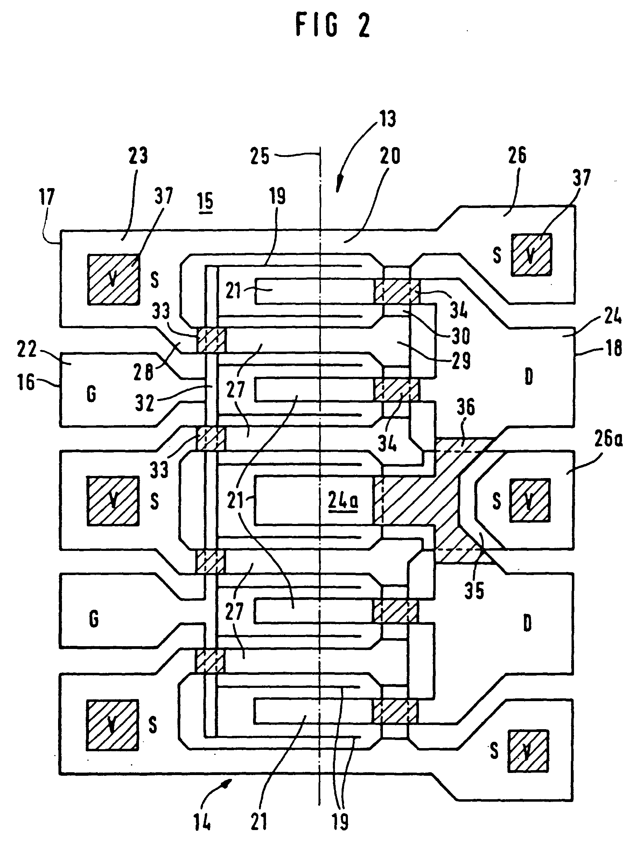

Bei dem in Figur 2 dargestellten Ausführungsbeispiel eines erfindungsgemäßen Halbleiter-Bauelementes 13 ist ein GaAs-Feldeffekttransistor mit Multifingeranordnung 14 auf einem GaAs-Halbleitersubstrat 15 ausgebildet. Der Transistor besitzt einen ersten Elektrodenanschlußbereich 16, der dem Gate G des Transistors zugeordnet ist, einen zweiten Elektrodenanschlußbereich 17, der dem Sourceanschluß S des Transistors zugeordnet ist, sowie einen dritten Elektrodenanschlußbereich 18, der dem Drainanschluß D des Transistors zugeordnet ist, welche Elektrodenanschlußbereiche 16, 17, 18 die in Fig. 2 dargestellte Anschlußtopologie aufweist. Die Anschlußtopologie gemäß Fig. 2 ist bzgl. der äußeren Anschlüsse 16, 17, 18 in etwa maßstabsgerecht dargestellt, wobei 1 cm in der Figur etwa 50 µm in der Realität entsprechen, welche dargestellte Anschlußtopologie mit allen geometrischen Einzelheiten und sonstigen zeichnerischen Merkmalen vollinhaltlich zum Offenbarungsinhalt der vorliegenden Anmeldung gerechnet werden. Jeder Elektrodenanschlußbereich 16, 17, 18 besteht aus Fingerabschnitten 19, 20, 21 mit einem gegenüber der Erstreckung in der Breite erheblich größeren Längserstreckung und einem mit dem zugehörenden Fingerabschnitt 19, 20, 21 elektrisch leitend verbundenen Kontaktflächenabschnitt 22, 23, 24, dessen Fläche jeweils gegenüber der Fläche des einzelnen der Fingerabschnitte 19, 20, 21 erheblich vergrößert ist. Die Fingerabschnitte 19, 20, 21 von sämtlichen Elektrodenanschlußbereichen 16, 17, 18 sind parallel zueinander ausgerichtet und in Richtung einer Mittenlinie 25 (welche zur Bezeichnung der Anordnung auf der hiervon linken und rechten Seite bezüglich der Fingerabschnitte dient und darüberhinaus nicht notwendigerweise eine Symmetrielinie darstellt) nebeneinanderliegend auf dem Halbleitersubstrat 15 angeordnet. Diese sind nicht maßstäblich dargestellt. Insbesondere können erheblich mehr Einzelfinger 19, 20, 21 den einzelnen der äußeren Anschlußbereiche 16, 17, 18 zugeordnet sein. Der dem Sourceanschluß zugeordnete Elektrodenanschlußbereich 17 besitzt neben dem auf der einen Seite bezüglich der Mittenlinie 25 angeordneten Kontaktflächenabschnitt 23 einen weiteren Kontaktflächenabschnitt 26, der auf der gegenüberliegenden Seite bezüglich der Mittenlinie 25, bei der Darstellung gemäß Fig. 2 auf der rechten Seite angeordnet ist und der gleichfalls eine gegenüber dem einzelnen Fingerabschnitt 20 vergrößerte Fläche wie dargestellt besitzt. Des weiteren besitzt der dem Sourceanschluß zugeordnete Elektrodenanschlußbereich 17 einen weiteren Fingerabschnitt 27, der sich ausgehend von dem einen Kontaktflächenabschnitt 23 über eine Abknickung 28 parallel zu den anderen Fingerabschnitten 19, 20, 21 erstreckt und in einen damit verbundenen Abschnitt 29 mündet, der auf der gegenüberliegenden Seite bezüglich der Mittenlinie 25 angeordnet ist. Der Abschnitt 29 ist über einen Steg 30 mit dem Fingerabschnitt 20 verbunden. Der dem Gateanschluß des Transistors zugeordnete Elektrodenanschlußbereich 16 besitzt eine parallel zur Mittenlinie 25 verlaufende und in der Darstellung gemäß Fig. 2 auf der linken Seite angeordnete Zuleitung 32, der die elektrische Verbindung zwischen den einzelnen Fingerabschnitten 19 mit dem Kontaktflächenabschnitt 22 bewirkt. Wie dargestellt, sind die weiteren Fingerabschnitte 27 des dem Sourceanschluß zugeordneten Elektrodenanschlußbereiches 17 über eine Brücke 33 über die Zuleitung 32 geführt, welche Brücke 33 eine den Fingerabschnitt 27 gegenüber der Zuleitung 32 elektrisch isolierende Kreuzungsstelle bildet, die als Metall-Isolatorschicht-Metallkreuzung oder als Luftbrücke ausgebildet sein kann. In analoger Weise sind die Fingerabschnitte 21, die sich ausgehend von den nach der Darstellung gemäß Fig. 2 auf der rechten Seite angeordneten Kontaktflächenabschnitte 24 des Elektrodenanschlußbereiches 18 nach links erstrecken, vermittels einer Brücke 34 über den Steg 30 des Elektrodenanschlußbereiches 17 geführt, welche Brücke 34 eine Kreuzungsstelle zur elektrischen Isolation des Fingerabschnittes 21 von dem Steg 30 bildet und wiederum als Metall-Isolatorschicht-Metallkreuzung oder als Luftbrücke ausgebildet sein kann. Die beiden Kontaktflächenabschnitte 27 des Elektrodenanschlußbereiches 17 sind, wie aus Fig. 2 ersichtlich ist, über einen Verbindungsabschnitt 35 elektrisch miteinander und dem auf der gemäß Fig. 2 rechten Seite angeordneten und zwischen den Kontaktflächenabschnitten 24 des Elektrodenanschlußbereiches 18 angeordneten weiteren Kontaktflächenabschnitt 26a des Elektrodenanschlußbereiches 17 verbunden. Der dazwischen liegende Kontaktflächenabschnitt 24a des Elektrodenanschlußbereiches 18 kann wiederum über eine Brücke 36, welche über den Verbindungsabschnitt 35 führt, mit dem Fingerabschnitt 21 verbunden sein. Bei der Herstellung des Halbleiter-Bauelementes kann der dem Gateanschluß G zugeordnete Elektrodenanschlußbereich 16 zusammenhängend in einem Verfahrenschritt der Ausbildung einer ersten Metallisierungsebene gefertigt sein, und die dem Sourceanschluß S und dem Drainanschluß D zugeordneten Elektrodenanschlußbereiche 17 und 18 können in einem Arbeitsgang bei einem Verfahrenschritt der Ausbildung einer zweiten Metallisierungsebene gefertigt werden. Bei speziellen Verfahren können die Ebenen durch dieselbe Metallisierung erreicht werden.

Bei dem dargestellten Ausführungsbeispiel gemäß Fig. 2 sind die Kontaktflächenabschnitte 22 und 24 der Elektrodenanschlußbereiche 16 und 18 als sogenannte Bondpads ausgebildet, während die dem Sourceanschluß S zugeordneten Kontaktflächenabschnitte 23 und/oder die weiteren Kontaktflächenabschnitte 26 als sogenannte Via-hole-Kontakte, d.h. ein metallisiertes Loch durch das semiisolierende Substrat zur Durchkontaktierung zur Rückseite des Substrates ausgebildet sind, wie dies durch die schraffierten Bereiche 37 gemäß Fig. 2 dargestellt ist. Der Vorteil von beidseitigen Via-Reihen liegt insbesondere darin, bei lediglich minimal erhöhtem Platzbedarf eine wesentliche Verringerung der Induktivität zur Rückseite des Substrates hin zu erzielen, und bei ausreichend kleinem Abstand der Vias 37 zum aktiven Bereich und ausreichend dicker Metallisierung im Via 37 eine effektive Verringerung des Wärmewiderstandes zu erzielen, so daß die aufgrund der elektrischen Verlustleistung vor allem im aktiven Bereich entstehende Wärme besser abgeführt werden kann.

## Patentansprüche

1. Halbleiter-Bauelement mit einem Halbleitersubstrat (15) und wenigstens einem auf dem Halbleitersubstrat (15) ausgebildeten Transistor mit ersten, zweiten und dritten auf einer Hauptoberfläche des Halbleitersubstrats ausgebildeten und voneinander elektrisch isolierten Elektrodenanschlußbereichen (16, 17, 18), von denen einer (16) dem Gate- bzw. Basisanschluß, einer (17) dem Source- bzw. Emitteranschluß, und einer (18) dem Drain- bzw. Kollektoranschluß des wenigstens einen Transistors zugeordnet ist, wobei jeder Elektrodenanschlußbereich aus zumindest einem Fingerabschnitt (19, 20, 21) und einem mit dem zugehörenden Fingerabschnitt elektrisch leitend verbundenen Kontaktflächenabschnitt (22, 23, 24) ausgebildet ist, wobei wenigstens ein Elektrodenanschlußbereich (17), dessen Kontaktflächenabschnitt (23) auf einer Seite bezüglich der Fingerabschnitte (19, 20, 21) angeordnet ist, einen mit dem zugehörenden Fingerabschnitt (20) elektrisch verbundenen weiteren Kontaktflächenabschnitt (26, 26a) aufweist, welcher weitere Kontaktflächenabschnitt (26, 26a) auf der gegenüberliegenden Seite bezüglich der Fingerabschnitte (19, 20, 21) angeordnet ist, und wenigstens ein Elektrodenanschlußbereich (17), dessen Kontaktflächenabschnitt (23) auf der einen Seite bezüglich der Fingerabschnitte (19, 20, 21) angeordnet ist, einen mit diesem Kontaktflächenabschnitt (23) und/oder dem zugehörenden weiteren Kontaktflächenabschnitt (26, 26a) elektrisch verbundenen weiteren Fingerabschnitt (27) aufweist,
dadurch gekennzeichnet, daß
der weitere Fingerabschnitt (27) über einen Steg (30) mit dem Fingerabschnitt (20), und/oder mit dem weiteren Kontaktflächenabschnitt (26, 26a) auf der gegenüberliegenden Seite bezüglich der Fingerabschnitte (19, 20, 21) des zugehörenden Elektrodenanschlußbereiches (17) elektrisch verbunden ist, und der Fingerabschnitt (21) eines auf der gegenüberliegenden Seite bezüglich der Fingerabschnitte (19, 20, 21) und zum Steg (30) nächstliegend angeordneten Kontaktflächenabschnittes (24) eines benachbarten Elektrodenanschlußbereiches (18) den Steg (30) elektrisch isolierend überkreuzend unter Bildung einer Kreuzungsstelle (34) ausgebildet ist.

2. Halbleiter-Bauelement nach Anspruch 1,
dadurch gekennzeichnet, daß
der dem Gate- bzw. Basisanschluß des Transistors zugeordnete Elektrodenanschlußbereich (16) eine Vielzahl von Fingerabschnitten (19) besitzt, die elektrisch leitend mit dem zugehörigen Kontaktflächenabschnitt (22) des dem Gate- bzw. Basisanschluß des Transistors zugeordneten Elektrodenanschlußbereiches (16) verbunden und parallel zwischen den Fingerabschnitten (21, 27) der dem Source- bzw. Emitteranschluß und dem Drain- bzw. Kollektoranschluß des Transisters zugeordneten Elektrodenanschlußbereichen (17, 18) verlaufen.

3. Halbleiter-Bauelement nach Anspruch 2,
dadurch gekennzeichnet, daß
die Vielzahl von Fingerabschnitten des dem Gate- bzw. Basisanschluß des Transistors zugeordneten Elektrodenanschlußbereiches über eine Zuleitung (32) mit dem dazugehörenden Kontaktflächenabschnitt (22) des Gate- bzw. Basisanschlusses verbunden sind.

4. Halbleiter-Bauelement nach Anspruch 3,
dadurch gekennzeichnet, daß
der Fingerabschnitt (27) des auf der einen Seite bezüglich der Fingerabschnitte (19, 20, 21) angeordneten Kontaktflächenabschnittes (23) eines Elektrodenanschlußbereiches (17) die dem Gate- bzw. Basisanschluß des Transistors zugeordnete Zuleitung (32) elektrisch isolierend überkreuzend unter Bildung einer Kreuzungsstelle (33) ausgebildet ist.

5. Halbleiter-Bauelement nach Anspruch 1 bis 4,
dadurch gekennzeichnet, daß
die Kreuzungsstelle (33, 34) als Metall-Isolatorschicht-Metallkreuzung oder als Luftbrücke ausgebildet ist.

6. Halbleiter-Bauelement nach Anspruch 1 bis 5,
dadurch gekennzeichnet, daß
eine Vielzahl von Transistoren vorgesehen ist, wobei die einen Kontaktflächenabschnitte (23) der dem Source- bzw. Emitteranschluß der Transistoren zugeordneten Elektrodenanschlußbereiche (17) und die Kontaktflächenabschnitte (22) der dem Gate- bzw. Basisanschluß der Transistoren zugeordneten Elektrodenanschlußbereiche (16) abwechselnd und in einer Reihe auf der einen Seite bezüglich der Fingerabschnitte (19, 20, 21) ausgerichtet sind, und die weiteren Kontaktflächenabschnitte (26) der dem Source- bzw. Emitteranschluß der Transistoren zugeordneten Elektrodenanschlußbereiche (17) und die Kontaktflächenabschnitte (24) der dem Drain- bzw. Kollektoranschluß der Transistoren zugeordneten Elektrodenanschlußbereiche (18) auf der gegenüberliegenden Seite bezüglich der Fingerabschnitte (19, 20, 21) abwechselnd und in einer Reihe ausgerichtet sind.

7. Halbleiter-Bauelement nach Anspruch 1 bis 6,
dadurch gekennzeichnet, daß
die Verbindung auf den Fingerabschnitten (27), die dem einen Anschlußbereich (17) zugeordnet sind, unter Bildung einer isolierenden Kreuzungsstelle (33) über die zum Gate- bzw. Basisanschluß (16) gehörenden Zuleitung (32) geführt ist, und gleichzeitig auf der gegenüberliegenden Seite bezüglich der Fingerabschnitte (19, 20, 21) unter Bildung von ebenfalls isolierenden Kreuzungsstellen als Stege (30, 35) unterhalb den zum dritten Elektrodenanschlußbereich (18) zugehörenden Zuführungen (34, 36) geführt ist.

8. Halbleiter-Bauelement nach Anspruch 1 bis 7,
dadurch gekennzeichnet, daß
die einen Kontaktflächenabschnitte (23) und/oder die weiteren Kontaktflächenabschnitte des dem Source- bzw. Emitteranschluß des wenigstens einen Transistors zugeordneten Elektrodenanschlußbereiches (17) eine Substratdurchkontaktierung (37) aufweisen.

9. Halbleiter-Bauelement nach Anspruch 1 bis 8,
dadurch gekennzeichnet, daß
der zumindest eine Transistor ein Feldeffekttransistor ist, und das Halbleitersubstrat GaAs aufweist.

10. Halbleiter-Bauelement nach Anspruch 1 bis 9,
dadurch gekennzeichnet, daß
das Halbleiterbauelement ein monolithisch integrierter Hochfrequenz-Schaltkreis ist.

## Claims

1. Semiconductor device having a semiconductor substrate (15) and at least one transistor, formed on the semiconductor substrate (15), having first, second and third electrode terminal regions (16, 17, 18), which are formed on a main surface of the semiconductor substrate and are electrically insulated from one another and of which one (16) is assigned to the gate and/or base terminal, one (17) is assigned to the source and/or emitter terminal, and one (18) is assigned to the drain and/or collector terminal of the at least one transistor, each electrode terminal region being formed from at least one finger section (19, 20, 21) and a contact area section (22, 23, 24) which is electrically conductively connected to the associated finger section, at least one electrode terminal region (17) whose contact area section (23) is arranged on one side with respect to the finger sections (19, 20, 21) having a further contact area section (26, 26a) which is electrically connected to the associated finger section (20), which further contact area section (26, 26a) is arranged on the opposite side with respect to the finger sections (19, 20, 21), and at least one electrode terminal region (17) whose contact area section (23) is arranged on one side with respect to the finger sections (19, 20, 21) having a further finger section (27) which is electrically connected to this contact area section (23) and/or to the associated further contact area section (26, 26a),
characterized in that
the further finger section (27) is electrically connected via a web (30) to the finger section (20) and/or to the further contact area section (26, 26a) on the opposite side with respect to the finger sections (19, 20, 21) of the associated electrode terminal region (17), and the finger section (21) of a contact area section (24) of an adjacent electrode terminal region (18), which contact area section is arranged on the opposite side with respect to the finger sections (19, 20, 21) and nearest to the web (30), is formed in such a way as to cross the web (30) in an electrically insulating manner with the formation of a crossover point (34).

2. Semiconductor device according to Claim 1,
characterized in that
the electrode terminal region (16) assigned to the gate and/or base terminal of the transistor has a multiplicity of finger sections (19) which are electrically conductively connected to the associated contact area section (22) of the electrode terminal region (16) assigned to the gate and/or base terminal of the transistor and run parallel between the finger sections (21, 27) of the electrode terminal regions (17, 18) assigned to the source and/or emitter terminal and the drain and/or collector terminal of the transistor.

3. Semiconductor device according to Claim 2,
characterized in that
the multiplicity of finger sections of the electrode terminal region assigned to the gate and/or base terminal of the transistor are connected via a lead (32) to the associated contact area section (22) of the gate and/or base terminal.

4. Semiconductor device according to Claim 3,
characterized in that
the finger section (27) of the contact area section (23) of an electrode terminal region (17), which contact area section is arranged on one side with respect to the finger sections (19, 20, 21), is formed in such a way as to cross the lead (32), assigned to the gate and/or base terminal of the transistor, in an electrically insulating manner with the formation of a crossover point (33).

5. Semiconductor device according to Claims 1 to 4,
characterized in that
the crossover point (33, 34) is formed as a metal/ insulator-layer/metal crossover or as an air bridge.

6. Semiconductor device according to Claims 1 to 5,
characterized in that
a multiplicity of transistors are provided, the first contact area sections (23) of the electrode terminal regions (17) assigned to the source and/or emitter terminal of the transistors and the contact area sections (22) of the electrode terminal regions (16) assigned to the gate and/or base terminal of the transistors are aligned alternately and in a row on one side with respect to the finger sections (19, 20, 21), and the further contact area sections (26) of the electrode terminal regions (17) assigned to the source and/or emitter terminal of the transistors and the contact area sections (24) of the electrode terminal regions (18) assigned to the drain and/or collector terminal of the transistors being aligned alternately and in a row on the opposite side with respect to the finger sections (19, 20, 21).

7. Semiconductor device according to Claims 1 to 6,
characterized in that
the connection on the finger sections (27) which are assigned to the first terminal region (17) is led, with the formation of an insulating crossover point (33), across the lead (32) associated with the gate and/or base terminal (16), and at the same time, on the opposite side with respect to the finger sections (19, 20, 21), is led, with the formation of likewise insulating crossover points, as webs (30, 35) underneath the feeders (34, 36) associated with the third electrode terminal region (18).

8. Semiconductor device according to Claims 1 to 7,
characterized in that
the first contact area sections (23) and/or the further contact area sections of the electrode terminal region (17) assigned to the source and/or emitter terminal of the at least one transistor have a substrate plated-through hole (37).

9. Semiconductor device according to Claims 1 to 8,
characterized in that
the at least one transistor is a field-effect transistor, and the semiconductor substrate has GaAs.

10. Semiconductor device according to Claims 1 to 9,
characterized in that
the semiconductor device is a monolithic high-frequency integrated circuit.

## Revendications

1. Composant à semi-conducteur comportant un substrat (15) semi-conducteur et au moins un transistor réalisé sur le substrat (15) semi-conducteur, comportant des première (16), deuxième (17) et troisième (18) zones de borne d'électrode qui sont réalisées sur une surface principale du substrat semi-conducteur et isolées du point de vue électrique les unes des autres, dont l'une (16) est associée à la borne de grille ou de base, dont l'une (17) est associée à la borne de source ou d'émetteur et dont l'une (18) est associée à la borne de drain ou de collecteur du au moins un transistor, chaque zone de borne d'électrode étant constituée d'au moins un tronçon (19, 20, 21) de doigt et d'une partie (22, 23, 24) de surface de contact reliée de manière conductrice de l'électricité au tronçon de doigts associé, au moins une zone (17) de borne d'électrode dont la partie (23) de surface de contact est disposée d'un côté par rapport aux tronçons (19, 20, 21) de doigt, comportant une partie (26, 26a) supplémentaire de surface de contact reliée du point de vue électrique au tronçon (20) de doigt associé, cette partie (26, 26a) supplémentaire de surface de contact étant disposée du côté opposé par rapport aux tronçons (19, 20, 21) de doigt, et au moins une zone (17) de borne d'électrode dont la partie (23) de surface de contact est disposée d'un côté par rapport aux tronçons (19, 20, 21) de doigt comportant un tronçon (27) supplémentaire de doigt relié du point de vue électrique à cette partie (23) de surface de contact et/ou à la partie (26, 26a) supplémentaire de surface de contact associée,
caractérisé en ce que
le tronçon (27) supplémentaire de doigts est relié du point de vue électrique, par l'intermédiaire d'une barrette (30), au tronçon (20) de doigt et/ou à la partie (26, 26a) supplémentaire de surface de contact du côté opposé par rapport aux tronçons (19, 20, 21) de doigt de la zone (17) de borne d'électrode associée,
et le tronçon (21) de doigt d'une partie (24) de surface de contact, disposée du côté opposé par rapport aux tronçons (19, 20, 21) de doigt et au plus près de la barrette (30), d'une zone (18) de borne d'électrode voisine est réalisé en croisant la barrette (30) de manière isolante du point de vue électrique, avec formation d'un point (34) d'intersection.

2. Composant à semi-conducteur suivant la revendication 1,
caractérisé en ce que la zone (16) de borne d'électrode associée à la borne de grille ou de base du transistor a une pluralités de tronçons (19) de doigt, qui sont reliés de manière conductrice de l'électricité à la partie (22) de surface de contact associée de la zone (16) de borne d'électrode associée à la borne de grille ou de base du transistor et qui s'étendent parallèlement entre les tronçons (21, 27) de doigt des zones (17, 18) de borne d'électrode associées à la borne de source ou d'émetteur et à la borne de drain ou de collecteur du transistor.

3. Composant à semi-conducteur suivant la revendication 2,
caractérisé en ce que la pluralité de tronçons de doigt de la zone de borne d'électrode associée à la borne de grille ou de base du transistor sont reliés par l'intermédiaire d'une ligne (32) d'alimentation à la partie (22) de surface de contact associée du borne de grille ou de base.

4. Composant à semi-conducteur suivant la revendication 3,
caractérisé en ce que le tronçon (27) de doigt de la partie (23) de surface de contact, disposé d'un côté par rapport aux tronçons (19, 20, 21) de doigt, d'une zone (17) de borne d'électrode est réalisée en croisant de manière isolante du point de vue électrique la ligne (32) d'alimentation associée à la borne de grille ou de base du transistor, avec formation d'un point (33) d'intersection.

5. Composant à semi-conducteur suivant la revendication 1 à 4,
caractérisé en ce que le point (33, 34) d'intersection est réalisé en intersection métallique en métal et à couche isolante ou en pont aérien.

6. Composant à semi-conducteur suivant la revendication 1 à 5,
caractérisé en ce qu'il est prévu une pluralité de transistors, les unes des parties (23) de surface de contact des zones (17) de borne d'électrode associées à la borne de source ou d'émetteur des transistors et des parties (22) de surface de contact des zones (16) de borne d'électrode associées à la borne de grille ou de base des transistors étant orientées, en alternance et dans une rangée, de l'un des côtés par rapport aux tronçons (19, 20, 21) de doigt, et les parties (26) supplémentaires de surfaces de contact des zones (17) de borne d'électrode associées à la borne de source ou d'émetteur des transistors et les parties (24) de surfaces de contact des zones (18) de borne d'électrode associées à la borne de drain ou d'électrode des transistors étant orientées, en alternance et dans une rangée, du côté opposé par rapport aux tronçons (19, 20, 21) de doigt.

7. Composant à semi-conducteur suivant la revendication 1 à 6,
caractérisé en ce que la liaison sur les tronçons (27) de doigts qui sont associés à la une zone (17) de borne passe sur la ligne (32) d'alimentation faisant partie de la borne (16) de grille ou de base, et passe en même temps du côté opposé par rapport aux tronçons (19, 20, 21) de doigt, avec formation de points d'intersection également isolants, sous la forme de barrettes (30, 35), en-dessous des amenées (34, 36) faisant partie de la troisième zone (18) de borne d'électrode.

8. Composant à semi-conducteur suivant la revendication 1 à 7,
caractérisé en ce que les unes des parties (23) de surface de contact et/ou des parties supplémentaires de surfaces de contact de la zone (17) de borne d'électrode associée à la borne de source ou d'émetteur du au moins un transistor comporte une interconnexion (37) dans le substrat.

9. Composant à semi-conducteur suivant la revendication 1 à 8,
caractérisé en ce que le au moins un transistor est un transistor à effet de champ et comporte le substrat semi-conducteur GaAs.

10. Composant à semi-conducteur suivant la revendication 1 à 9, caractérisé en ce que le composant à semi-conducteur est un circuit intégré monolithique haute fréquence à semi-conducteur.
